# DEMANDE DE BREVET EUROPEEN

(11) **EP 1 246 357 A2**
(43) Date de publication de la demande: **02.10.2002**
(21) Numéro de dépôt: 02290735.6
(22) Date de dépôt: 22.03.2002
(51) Int. Cl.: H03G 1/00

(54) **Dispositif amplificateur à commutation de gain, en particulier pour un téléphone mobile cellulaire**

(30) Priorité: 27.03.2001 FR 0104102
(71) Demandeur: STMicroelectronics S.A., 92120 Montrouge (FR)
(72) Inventeur: Garcia, Patrice, 38400 Saint-Martin-d'Hères (FR); Belot, Didier, 38140 Rives (FR)
(74) Mandataire: Casalonga, Axel

(57) **Abrégé**

Le dispositif amplificateur à commutation de gain, comprend un moyen d'amplification (Q1), un circuit de charge (M1, M2) configurable comportant un élément inductif (L2) et capable de présenter deux configurations différentes ayant respectivement deux valeurs d'impédance différentes, et un moyen de commutation commandable (Q2, Q3) connecté entre le moyen d'amplification et le circuit de charge pour sélectionner l'une ou l'autre des deux configurations du circuit de charge. Le circuit de charge comporte deux transistors de charge à effet de champ à grilles isolées (M1, M2) connectés en série et fonctionnant en triode, l'élément inductif étant connecté en parallèle sur la paire de transistors de charge entre une borne d'alimentation et le circuit de commutation.

## Description

L'invention concerne les dispositifs amplificateurs à commutation de gain, et plus particulièrement les dispositifs amplificateurs à faible bruit (LNA : « low noise amplifier ») comme par exemple, ceux utilisés dans les têtes de réception de signaux radio-fréquence.

L'invention s'applique notamment mais non exclusivement aux amplificateurs à faible bruit à commutation de gain et aux têtes de réception radio-fréquence destinées aux circuits de téléphonique mobile.

Habituellement, les amplificateurs d'entrée faible bruit d'une chaîne de réception radio-fréquence disposent d'une commutation de gain permettant de réduire la contrainte de dynamique imposée sur le premier étage de conversion de fréquence.

Un tel amplificateur fonctionne généralement selon deux modes, un mode dit « fort gain » et un mode dit « bas gain ».

En mode « fort gain », le gain en puissance de l'amplificateur doit être suffisant, typiquement supérieur à 15dB. Cependant, en présence de signaux de plus forte puissance, le gain de l'amplificateur est coupé et l'on se situe alors dans un fonctionnement en mode « bas gain », dans lequel le gain est typiquement de l'ordre de -5dB.

Afin de maintenir constante l'adaptation en puissance de l'amplificateur dans les deux modes de gain, on utilise généralement une structure du type comprenant un moyen d'amplification, généralement un transistor bipolaire qui constitue le coeur de l'amplificateur, un circuit de charge configurable comportant un élément inductif et deux éléments résistifs et capable de présenter deux configurations différentes ayant respectivement deux valeurs d'impédance différentes, et un moyen de commutation commandable connecté entre le moyen d'amplification et le circuit de charge pour sélectionner l'une ou l'autre des deux configurations du circuit de charge. Ce moyen de commutation est généralement formé de deux transistors bipolaires dont l'un est connecté à la borne commune des deux éléments résistifs et dont l'autre est connecté à la borne commune entre l'un des éléments résistifs et l'élément inductif.

La sélection entre le mode « fort gain » et le mode « bas gain » s'effectue en bloquant l'un des deux transistors du moyen de commutation pendant que l'autre est maintenu passant. En mode « fort gain », le gain en puissance est fonction (en première approximation) du courant de polarisation du transistor du moyen d'amplification, de l'inductance de dégénérescence connectée sur l'émetteur du transistor, et des pertes des réseaux d'adaptation présents en entrée et en sortie de l'amplificateur. Cependant, le gain en puissance est limité par la valeur de la résistance connectée entre les deux transistors de commutation, et dont la valeur doit être suffisamment élevée.

En mode « bas gain », le gain en puissance est fixé par le rapport des deux résistances qui doit être de l'ordre de 1/10^{ème} pour obtenir une atténuation de -5dB, ce qui correspond à environ 20dB de moins qu'en mode « fort gain ».

Dans les systèmes de communication sans fil, du type de ceux fonctionnant selon la norme WCDMA (« Wide Band CDMA »), bien connue de l'homme du métier, il est spécifié d'obtenir un gain relativement élevé en mode « fort gain », typiquement un gain de l'ordre de 16dB. Or, compte tenu des valeurs de résistance utilisées, le gain maximum disponible pour l'amplificateur atteint difficilement cette valeur.

Par ailleurs, en mode « bas gain », la valeur de l'autre résistance, qui doit être dix fois plu faible que celle de la résistance précédemment citée, est à l'origine d'une surtension interne sur le collecteur de l'un des deux transistors de commutation. Le point de compression est donc limité par la dynamique du signal alors que l'amplificateur fonctionne en atténuateur.

En conclusion, dans les dispositifs d'amplification classique, le choix des valeurs des éléments résistifs du circuit de charge résulte d'un compromis entre le gain en mode « fort gain » et le point de compression en mode « bas gain ».

L'invention vise à remédier à cet inconvénient.

Un but de l'invention est d'optimiser la dynamique de sortie en mode « bas gain » tout en maintenant un gain élevé en mode « fort gain ».

L'invention propose donc un dispositif amplificateur à commutation de gain, comprenant un moyen d'amplification, un circuit de charge configurable comportant un élément inductif et capable de présenter deux configurations différentes ayant respectivement deux valeurs d'impédance différentes et un moyen de commutation commandable connecté entre le moyen d'amplification et le circuit de charge pour sélectionner l'une ou l'autre des deux configurations du circuit de charge.

Selon une caractéristique générale de l'invention, le circuit de charge comporte deux transistors de charge à effet de champ à grille isolée connectés en série et fonctionnant en triode, l'élément inductif étant connecté en parallèle sur la paire de transistors de charge entre une borne d'alimentation et le circuit de commutation.

Le fonctionnement en triode des transistors de charge, c'est-à-dire la commande par la tension de grille de la circulation du courant entre la source et le drain, permet de rendre bloqués ou passants ces transistors de charge en fonction du gain souhaité. Plus précisément, quand les transistors de charge sont bloqués, ils se comportent comme un réseau capacitif conduisant à un gain maximum tandis que lorsqu'ils sont passants, ils se comportent comme des résistances permettant d'abaisser le gain. En mode « fort gain », c'est-à-dire lorsque les transistors sont bloqués, ils n'introduisent pas de perte résistive.

Selon un mode de réalisation de l'invention, les deux transistors de charge sont tous deux commandables sur la grille par un même signal de commande (tension de grille). Une première borne de l'élément inductif est connectée à la borne d'alimentation et la deuxième borne de l'élément inductif est connectée à une première entrée de commutation du moyen de commutation. La borne commune des deux transistors de charge est connectée à une deuxième entrée de commutation du moyen de commutation. Le dispositif comporte également des moyens de sélection aptes :
- à délivrer un signal de sélection au moyen de commutation de façon à sélectionner ladite configuration, et
- à délivrer ledit signal de commande de façon à rendre les deux transistors bloqués ou passants en fonction de la configuration sélectionnée.

Selon un mode de réalisation de l'invention, le moyen de commutation comporte un premier transistor de commutation connecté entre le moyen d'amplification et ladite première entrée de commutation, et un deuxième transistor de commutation connecté entre le moyen d'amplification et ladite deuxième entrée de commutation. Dans une première configuration du circuit de charge (correspondant par exemple à un mode fort gain), les transistors de charge sont bloqués, le premier transistor de commutation est passant et le deuxième transistor de commutation est bloqué.

Dans une deuxième configuration du circuit de charge (correspondant par exemple au mode bas gain), les transistors de charge sont passants, le premier transistor de commutation est bloqué et le deuxième transistor de commutation est passant.

En mode « bas gain », c'est-à-dire dans la deuxième configuration, le transistor de charge connecté entre les deux entrées de commutation doit présenter la résistance la plus élevée. Il en résulte donc que ce transistor de charge présente une largeur de canal inférieure à celle de l'autre transistor de charge, qui doit présenter une résistance beaucoup plus faible. Ceci est particulièrement avantageux, car le transistor le plus petit qui est connecté entre le collecteur du deuxième transistor de commutation et l'élément inductif, présentent une capacité parasite de faible valeur qui est beaucoup plus facile à gérer qu'une capacité de plus grande valeur.

Alors qu'il serait possible d'utiliser comme transistors de charge des transistors NMOS, on utilisera de préférence des transistors de charge de type PMOS ce qui permet de les commander sur leur grille par une tension de commande positive. Par ailleurs, afin d'éviter que ces transistors PMOS n'entrent en conduction accidentellement en mode « fort gain » en présence d'un fort signal de sortie, on choisira avantageusement pour la tension de commande, une valeur au moins égale à celle de la tension d'alimentation augmentée de la tension de seuil de la diode drain-substrat d'un transistor de charge.

L'invention a également pour objet un récepteur radio-fréquence, par exemple un téléphone mobile cellulaire, incorporant un dispositif amplificateur selon l'invention.

D'autres avantages et caractéristiques de l'invention apparaîtront à l'examen de la description détaillée d'un mode de réalisation, nullement limitatif, et des dessins annexés sur lesquels :
- la figure 1 illustre schématiquement et partiellement certains constituants d'un téléphone mobile cellulaire selon l'invention, et notamment la tête de réception incorporant un dispositif amplificateur à faible bruit selon l'invention, et
- la figure 2 illustre plus en détails un mode de réalisation d'un dispositif amplificateur selon l'invention.

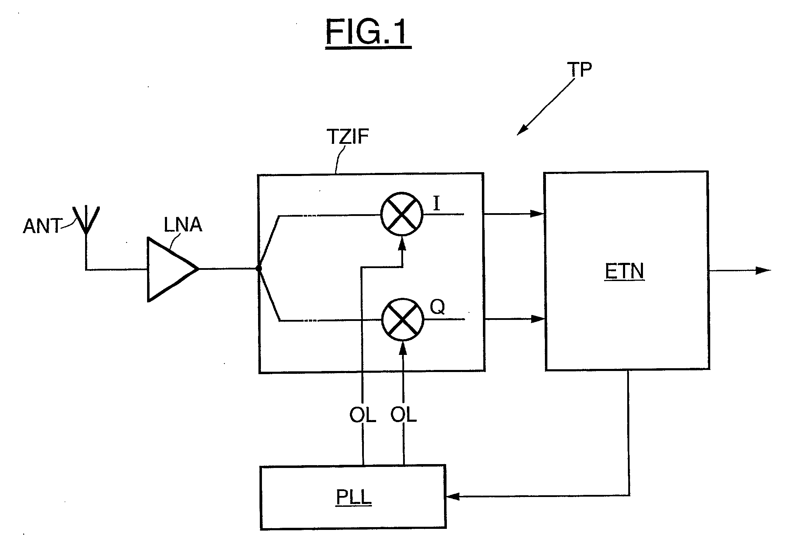

Sur la figure 1, la référence TP désigne un téléphone mobile cellulaire dont la tête de réception radiofréquence est apte à recevoir un signal radiofréquence (RF) qui provient d'une antenne de réception ANT en transitant, le cas échéant, par un coupleur d'antenne et/ou un transformateur d'isolement (non représenté).

Le signal RF est envoyé sur un amplificateur à faible bruit LNA. La sortie de l'amplificateur LNA est connectée à un synthonisateur ou tuner TZIF, de structure classique et connue en soi. Ce tuner TZIF comporte ainsi notamment sur ses deux voies de traitement des filtres passe-bande, des amplificateurs à gain commandé, et deux mélangeurs recevant respectivement de la part d'une boucle à verrouillage de phase deux signaux d'oscillateur local OL mutuellement déphasés de 90°, de façon à définir une voie de référence (en phase), à savoir la voie I, et une voie en quadrature, à savoir la voie Q.

La fréquence des signaux d'oscillateur local OL définit la fréquence nominale de la bande fréquentielle de réception sélectionnée par le téléphone portable. Le tuner TZIF est couplé, par l'intermédiaire d'un étage de conversion analogique-numérique, à un étage numérique de traitement, réalisé matériellement en partie au moyen d'une logique câblée et en partie au moyen d'un processeur de traitement du signal.

La structure et les fonctions d'un tel étage ETN sont également bien connues de l'homme du métier. Plus précisément, fonctionnellement, l'étage de traitement comporte (outre des moyens d'estimation de la réponse impulsionnelle du canal de transmission, des moyens de suppression des interférences intersymbole (égaliseur), et un bloc de décodage de canal), des moyens de modulation/démodulation capables d'effectuer la démodulation du signal reçu et la modulation du signal à émettre via une chaîne d'émission (non représentée sur la figure 1 à des fins de simplification).

Par ailleurs, comme il est classique dans les téléphones portables, des moyens de contrôle automatique de fréquence délivrent, après démodulation d'un signal pilote, un mot de commande à la boucle à verrouillage de phase PLL (par exemple à un oscillateur commandé en tension et stable en température (oscillateur VTCXO) servant de référence à la boucle PLL), de façon à contrôler la précision des signaux d'oscillateur local OL.

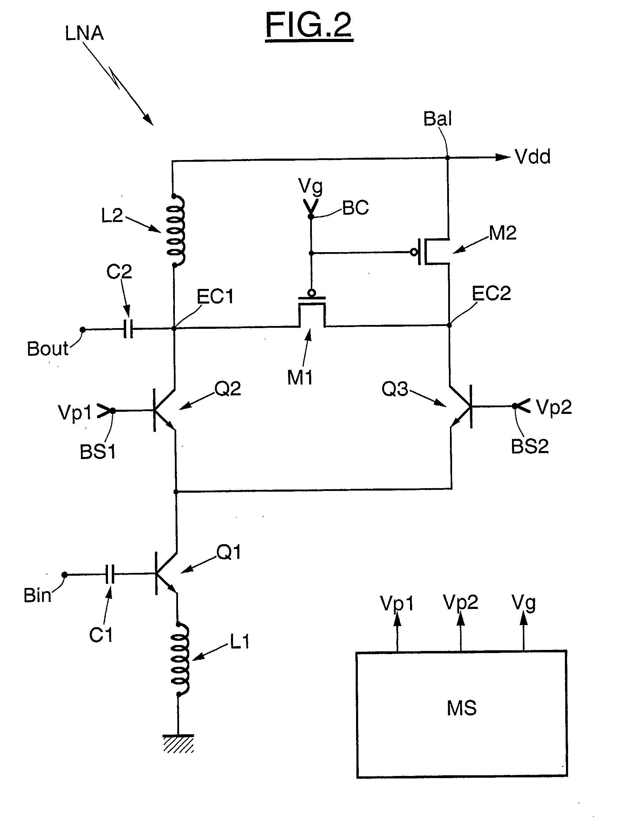

L'amplificateur à faible bruit LNA est un amplificateur à commutation de gain dont on va maintenant décrire un exemple de réalisation de structure à entrée unique, en se référant plus particulièrement à la figure 2. Ceci étant, l'invention s'applique également à un amplificateur à structure différentielle.

Sur la figure 2, la référence Q1 désigne un transistor bipolaire formant le moyen d'amplification (coeur de l'amplificateur) proprement dit. Ce transistor Q1 est associé à un réseau d'adaptation d'entrée capacitif-inductif. Plus précisément, un condensateur d'entrée C1 est connecté entre la base du transistor Q1 et la borne d'entrée Bin de l'amplificateur LNA. Un élément inductif L1 est connecté entre l'émetteur du transistor Q1 et la masse.

Un circuit de commutation de courant est connecté sur le collecteur du transistor Q1. Ce circuit de commutation est essentiellement formé de deux transistors de commutation bipolaires Q2 et Q3.

Plus précisément, l'émetteur du premier transistor de commutation Q2 est connecté au collecteur du transistor Q1. La base du transistor Q2 est reliée à une première borne de sélection BS1 apte à recevoir une tension de sélection Vp1. Le collecteur du transistor Q2 forme une première entrée de commutation EC1 pour le circuit de commutation.

Le collecteur du deuxième transistor de commutation Q3 forme une deuxième entrée de commutation EC2. L'émetteur de ce transistor Q3 est reliée au collecteur du transistor Q1 et la base du transistor Q3 est reliée à une deuxième borne de sélection BS2 destinée à recevoir une deuxième tension de sélection Vp2.

Un circuit de charge est par ailleurs connecté entre une borne d'alimentation Bal de l'amplificateur (alimentée à la tension d'alimentation Vdd) et les deux entrées de commutation EC1 et EC2 du circuit de commutation.

Plus précisément, le circuit de charge comporte un premier transistor de charge M1 et un deuxième transistor de charge. M2, connectés en série entre la première entrée de commutation EC1 et la borne d'alimentation Bal.

Ces deux transistors de charge M1, M2 sont des transistors PMOS dont les deux grilles respectives sont reliées ensemble à une borne de commande BC susceptible de recevoir une tension de commande Vg.

La borne commune des deux transistors M1 et M2 est reliée à la deuxième entrée de commutation EC2.

Par ailleurs, un élément inductif L2 est connecté en parallèle aux bornes de la paire de transistor de charge M1 et M1 entre la première entrée de commutation EC1 et la borne d'alimentation Bal.

Cet élément inductif L2 forme par ailleurs avec un condensateur C2, connecté entre la première entrée de commutation EC1 et une borne de sortie Bout de l'amplificateur, un réseau d'adaptation de sortie.

L'amplificateur LNA comporte par ailleurs des moyens de sélection MS destinés à délivrer les différentes tensions Vp1, Vp2 et Vg. Ces moyens MS peuvent être classiquement réalisés à partir de source de tension et d'éléments logiques de commutation par exemple.

Dans une première configuration du circuit de charge, correspondant à un mode « fort gain », les tensions de sélection (tension de base) Vp1 et Vp2 des transistors Q2 et Q3 sont par exemple maintenues autour de 1,8 Volt et de 1,1 Volt respectivement, afin de rendre le premier transistor de commutation Q2 passant et le deuxième transistor de commutation Q3 bloqué.

Par ailleurs, la tension de grille Vg est portée à une valeur au moins égale à la tension d'alimentation Vdd augmentée de la tension de seuil de la diode drain-substrat de chaque transistor de charge. Ainsi, à titre d'exemple si la tension d'alimentation Vdd est de l'ordre de 2,7 Volts on choisira une tension Vg au moins égale à 3,3 Volts. Ceci permet de conserver une tension grille-source Vgs pour chaque transistor de charge suffisamment élevée même en présence de forts signaux de sortie, de façon à éviter que les transistors M1 et M2, bloqués, ne rentrent accidentellement en conduction.

Dans cette configuration, les transistors de charge M1 et M2, bloqués, se comportent comme deux condensateurs connectés en parallèle sur l'élément inductif L2. Il n'y a pas de perte résistive et par conséquent pas de limitation du gain occasionné par de telles pertes résistives.

Par ailleurs, l'impédance d'entrée du transistor de charge M1 est alors suffisamment forte pour ne pas dégrader le gain. Et, le gain maximum disponible peut être par exemple de l'ordre de 20 dB à 2 GHZ, ce qui représente une amélioration par rapport à un montage classique utilisant des éléments résistifs.

Bien entendu, l'homme du métier saura choisir la surface des transistors de charge M1 et M2 de façon à déterminer leur valeur capacitive permettant de se caler correctement sur la fréquence du signal à amplifier.

Dans la seconde configuration du circuit de charge, les tensions Vp1 et Vp2 sont maintenues par exemple autour de 1,1 Volt et de 1,8 Volt respectivement, afin cette fois-ci de rendre le premier transistor de commutation Q2 bloqué et le deuxième transistor de commutation Q3 passant.

Par ailleurs, dans cette seconde configuration, la tension de grille Vg est maintenue par exemple à 0 Volt, ce qui rend les transistors M1 et M2 passants. Ces transistors, polarisés en zone ohmique, se comportent alors comme des résistances de faible valeur ce qui permet d'obtenir par exemple un gain de l'ordre de -3db. Le gain minimum en puissance est fixé par le rapport des valeurs de résistance des transistors M1 et M2 c'est-à-dire par le rapport des largeurs de canal W1 et W2. L'homme du métier saura également ajuster la dimension des transistors de charge M1 et M2 pour obtenir le gain minimum souhaité.

Par ailleurs, il convient de noter que la valeur résistive du transistor M1 doit être beaucoup plus élevée que la valeur résistive du transistor M2. En conséquence, le transistor M1 doit présenter une surface beaucoup plus petite que la surface du transistor M2, ce qui conduit avantageusement à l'obtention d'une capacité parasite plus faible lors d'un fonctionnement en mode bas gain.

L'invention permet ainsi de choisir des valeurs de résistance plus faible en mode « bas gain », ce qui permet d'une part d'optimiser la dynamique de sortie, tout en maintenant d'autre part un gain élevé en mode « fort gain ».

## Revendications

1. Dispositif amplificateur à commutation de gain, comprenant un moyen d'amplification (Q1), un circuit de charge (M1, M2) configurable comportant un élément inductif (L2) et capable de présenter deux configurations différentes ayant respectivement deux valeurs d'impédance différentes, et un moyen de commutation commandable (Q2, Q3) connecté entre le moyen d'amplification et le circuit de charge pour sélectionner l'une ou l'autre des deux configurations du circuit de charge, **caractérisé par le fait que** le circuit de charge comporte deux transistors de charge à effet de champ à grilles isolées (M1, M2) connectés en série et fonctionnant en triode, l'élément inductif étant connecté en parallèle sur la paire de transistors de charge entre une borne d'alimentation et le circuit de commutation.

2. Dispositif selon la revendication 1, **caractérisé par le fait que** les deux transistors de charge tous deux commandables sur leurs grilles par un même signal de commande (Vg), **par le fait qu'**une première borne de l'élément inductif est connectée à la borne d'alimentation (Bal), et la deuxième borne de l'élément inductif est connectée à une première entrée de commutation du moyen de commutation (EC1), **par le fait que** la borne commune des deux transistors de charge est connectée à une deuxième entrée de commutation du moyen de commutation (EC2), et **par le fait que** le dispositif comporte également des moyens de sélection (MS) aptes
à délivrer un signal de sélection (Vp1, Vp2) au moyen de commutation de façon à sélectionner ladite configuration, et
à délivrer ledit signal de commande (Vg) de façon à rendre les deux transistors bloqués ou passants en fonction de la configuration sélectionnée.

3. Dispositif selon la revendication 2, **caractérisé par le fait que** le moyen de commutation comporte un premier transistor de commutation (Q2) connecté entre le moyen d'amplification et ladite première entrée, et un deuxième transistor de commutation (Q3) connecté entre le moyen d'amplification et ladite deuxième entrée, et **par le fait que** dans une première configuration du circuit de charge, les transistors de charge sont bloqués, le premier transistor de commutation est passant et le deuxième transistor de commutation est bloqué, tandis que dans une deuxième
configuration du circuit de charge, les transistors de charge sont passants, le premier transistor de commutation est bloqué et le deuxième transistor de commutation est passant.

4. Dispositif selon la revendication 3, **caractérisé par le fait que** le transistor de charge (M2) connecté entre la borne d'alimentation (Bal) et la deuxième entrée de commutation (EC2) présente une largeur de canal supérieure à celle de l'autre transistor de charge (M1).

5. Dispositif selon l'une des revendications précédentes, **caractérisé par le fait que** les deux transistors de charge sont des transistors PMOS commandés sur leur grille par une tension de commande dont la valeur est au moins égale à celle de la tension d'alimentation augmentée de la tension de seuil de la diode drain-substrat d'un transistor de charge.

6. Récepteur radiofréquence, **caractérisé par le fait qu'**il incorpore un dispositif amplificateur selon l'une des revendications 1 à 5.

7. Récepteur selon la revendication 6, **caractérisé par le fait qu'**il est un téléphone mobile cellulaire.
